(19) **Europäisches Patentamt**
**European Patent Office**
**Office européen des brevets**

(11) **EP 4 264 291 B1**

(12) **EUROPÄISCHE PATENTSCHRIFT**

(45) Veröffentlichungstag und Bekanntmachung des Hinweises auf die Patenterteilung:
**25.02.2026 Patentblatt 2026/09**

(21) Anmeldenummer: **22701303.4**

(22) Anmeldetag: **11.01.2022**

(51) Internationale Patentklassifikation (IPC):
***G01R 15/24*** *(2006.01)*

(52) Gemeinsame Patentklassifikation (CPC):
**G01R 15/246**

(86) Internationale Anmeldenummer:
**PCT/EP2022/050380**

(87) Internationale Veröffentlichungsnummer:
**WO 2022/179763 (01.09.2022 Gazette 2022/35)**

(54) **VERFAHREN ZUM ÜBERWACHEN ZUMINDEST EINES HALBLEITERELEMENTS IN EINEM HALBLEITERMODUL**

METHOD FOR MONITORING AT LEAST ONE SEMICONDUCTOR ELEMENT IN A SEMICONDUCTOR MODULE

PROCÉDÉ DE SURVEILLANCE D'AU MOINS UN ÉLÉMENT À SEMI-CONDUCTEUR DANS UN MODULE DE SEMI-CONDUCTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2021 EP 21159313**

(43) Veröffentlichungstag der Anmeldung:
**25.10.2023 Patentblatt 2023/43**

(73) Patentinhaber: **Siemens Aktiengesellschaft**
**80333 München (DE)**

(72) Erfinder:
• **WETZEL, Ulrich**
**91325 Adelsdorf (DE)**
• **ZETTNER, Jürgen**
**90587 Veitsbronn (DE)**

(74) Vertreter: **Siemens Patent Attorneys**
**Postfach 22 16 34**
**80506 München (DE)**

(56) Entgegenhaltungen:
**EP-A1- 3 358 359      DE-A1- 102012 002 984**
**US-A- 5 486 754**

• **ARAKELYAN SHANT ET AL: "Direct current imaging using a magneto-optical sensor", SENSORS AND ACTUATORS A: PHYSICAL, ELSEVIER BV, NL, vol. 238, 11 January 2016 (2016-01-11), pages 397 - 401, XP029399655, ISSN: 0924-4247, DOI: 10.1016/ J.SNA.2016.01.002**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Überwachen zumindest eines Halbleiterelements in einem Halbleitermodul.

Ferner betrifft die Erfindung eine Steuereinheit mit Mitteln zur Durchführung eines derartigen Verfahrens.

Überdies betrifft die Erfindung ein Computerprogramm zur Durchführung eines derartigen Verfahrens bei Ablauf in einer Steuereinheit.

Des Weiteren betrifft die Erfindung die Verwendung eines magneto-optischen Sensors zur Ermittlung eines Stromes in einem Halbleitermodul.

Darüber hinaus betrifft die Erfindung ein Halbleitermodul.

Derartige Halbleitermodule werden beispielsweise in einem Stromrichter in der elektrischen Antriebstechnik eingesetzt. Unter einem Stromrichter ist beispielsweise ein Gleichrichter, ein Wechselrichter, ein Umrichter oder ein Gleichspannungswandler zu verstehen. Derartige Stromrichter sind stetig weiterer Optimierung unterworfen, wodurch es zum Einsatz verbesserter Halbleitermaterialien, geänderter Aufbau und Verbindungstechniken, kurz AVT, sowie verbesserter Entwärmungskonzepte kommt. Darüber hinaus kommen Monitoring-Lösungen zur Überwachung der Halbleitermodule zum Einsatz. Derartige Optimierung zielen insbesondere auf hohe Leistungsdichten, kompakte Bauweisen, hohe Effizienz und gesteigerte Zuverlässigkeit **ab.**

Die Monitoring-Lösungen umfassen Sensoren, die beispielsweise eine Messung eines Laststromes, eine Messung einer Gatespannung und/oder einer Temperatur ermöglichen. Derartige Sensoren dürfen die Halbleiterelemente und deren Peripherie, welche beispielsweise die AVT, insbesondere Zuleitungen, umfasst, nicht merklich beeinflussen. Ferner ist eine schnelle Reaktion der Sensoren auf dynamische elektrische Vorgänge, insbesondere transiente Schaltvorgänge, der Halbleiterelemente, welche beispielsweise im ms-Bereich oder gar im ps-Bereich liegen, erforderlich.

Der Artikel "Magneto-Optical Sensors"; Koschny, Marco; Lindner, Morris; Richert, Hendryk, Quality (2012) vol. 51, S. 6-9; ISSN 03609936, beschreibt eine die Einführung von magneto-optischen Sensoren zur direkten Feldvisualisierung. Erwähnt wird auch das Prinzip von magneto-optischen Sensoren, welches der Faraday-Effekt ist.

Der Artikel "Rapid Faraday Rotation on $\varepsilon$-Iron Oxide Magnetic Nanoparticles by Visible and Terahertz Pulsed Light"; Shinichi Ohkoshi; Kenta Imoto; Asuka Namai; Marie Yoshikiyo; Seiji Miyashita; Hongsong Qiu; Shodai Kimoto; Kosaku Kato; Makoto Nakajima, Journal of the American Chemical Society, 2019, 141 (4), 1775-1780, beschreibt eine Magnetisierungsumkehr, die durch gepulste Laser mit sichtbarem Licht induziert wird und einen ultraschnellen dynamischen magneto-optischen Effekt, der durch gepulste Laserbestrahlung im Terahertzbereich auf chemisch synthetisierte magnetische Filme auf Basis von Gallium-Titan-Kobalt-substituiertem $_2$-Fe$_2$O$_3$ (GTC-$_2$-Fe$_2$O$_3$) und $_E$-Fe2O3-Nanopartikeln verursacht wird. Die Bestrahlung mit sichtbarem Licht gepulster Laser schaltet das Vorzeichen des Faraday-Effekts in GTC-$_2$-Fe$_2$O$_3$-Filmen um. Auf der anderen Seite induziert die Bestrahlung des $_2$-Fe$_2$O$_3$-Films mit gepulstem THz-Licht eine ultraschnelle Faraday-Rotation in einer extrem kurzen Zeit von 400 fs.

Der Offenbarungsgehalt der Artikel "Magneto-Optical Sensors" und "Rapid Faraday Rotation on $\varepsilon$-Iron Oxide Magnetic Nanoparticles by Visible and Terahertz Pulsed Light" wird durch Verweis in die vorliegende Anmeldung mit einbezogen.

Die Offenlegungsschrift EP 3 358 359 A1 beschreibt eine Leiterplatte mit einer Leiterbahn aufweisend eine Aussparung, welche derart im Verlauf der Leiterbahn angeordnet ist, dass die Leiterbahn unterbrochen ist, wobei in der Aussparung ein Implantat mit einem linken, rechten, unteren und oberen Rand angeordnet ist, wobei in dem Implantat ein Leiter angeordnet ist, welcher bei eingesetztem Implantat die durch die Aussparung aufgetrennte Leiterbahn schließt, wobei das Implantat eine erste optische Schicht und eine zweite optische Schicht aufweist und der Leiter zwischen den beiden Schichten angeordnet ist.

Der Artikel "Direct current imaging using a magneto-optical sensor"; Arakelyan Shant et al; Sensors and Actuators: Physical, Elsevier BV, NL BV, NL, Bd. 238, 11. Januar 2016, Seiten 397-401 beschreibt magneto-optische Bildgebung für die Visualisierung von Gleichströmen von strukturierter Stromverdrahtung unter Verwendung von Bismutsubstituierten Yttrium-Eisen-Granat Sensorschichten.

Die Offenlegungsschrift DE 10 2012 002 984 A1 beschreibt einen integrierten optischen Schaltkreis zur Strommessung auf Grundlage des Faraday-Effekts.

Vor diesem Hintergrund besteht die Aufgabe der vorliegenden Erfindung darin, ein Verfahren zum Überwachen zumindest eines Halbleiterelements in einem Halbleitermodul anzugeben, welches dynamische, insbesondere transiente, Vorgänge erfassen kann, ohne die Halbleiterelemente und deren Peripherie merklich zu beeinflussen.

Die Aufgabe wird erfindungsgemäß durch ein Verfahren zum Überwachen zumindest eines Halbleiterelements in einem Halbleitermodul gelöst, wobei das Halbleitermodul Zuleitungen zur Kontaktierung des Halbleiterelements aufweist, wobei ein magneto-optischer Sensor im Bereich des Halbleiterelements oder zumindest einer Zuleitung angeordnet ist, wobei ein polarisiertes Lichtsignal vom magneto-optischen Sensor reflektiert wird, wobei anhand einer Polarisation des reflektierten Lichtsignals ein Strom ermittelt wird, wobei der magneto-optische Sensor ein erstes magneto-optisches Material und ein zweites magneto-optisches Material, welches sich hinsichtlich einer Empfindlichkeit vom ersten magneto-optischen Material unterscheidet, umfasst, wobei mit dem ersten magneto-optischen Material ein erster Strom ermittelt wird, wobei mit dem zweiten magneto-optischen Material ein zweiter Strom ermittelt wird und wobei der zweite Strom höher als der erste Strom ist.

Ferner wird die Aufgabe erfindungsgemäß gelöst durch ein Verfahren zum Überwachen zumindest eines Halbleiterelements in einem Halbleitermodul, wobei das Halbleitermodul Zuleitungen zur Kontaktierung des Halbleiterelements aufweist, wobei ein magneto-optischer Sensor im Bereich des Halbleiterelements oder zumindest einer Zuleitung angeordnet ist, wobei ein polarisiertes Lichtsignal vom magneto-optischen Sensor transmittiert wird, wobei anhand einer Polarisation des transmittierten Lichtsignals ein Strom ermittelt wird, wobei der magneto-optische Sensor ein erstes magneto-optisches Material und ein zweites magneto-optisches Material, welches sich hinsichtlich einer Empfindlichkeit vom ersten magneto-optischen Material unterscheidet, umfasst, wobei mit dem ersten magneto-optischen Material ein erster Strom ermittelt wird, wobei mit dem zweiten magneto-optischen Material ein zweiter Strom ermittelt wird und wobei der zweite Strom höher als der erste Strom ist.

Überdies wird die Aufgabe erfindungsgemäß gelöst durch eine Anordnung aus einer Steuereinheit und einem magneto-optischem Sensor mit Mitteln zur Durchführung eines derartigen Verfahrens.

Des Weiteren wird die Aufgabe erfindungsgemäß gelöst durch ein Computerprogramm zur Durchführung eines derartigen Verfahrens bei Ablauf in einer solchen Anordnung Darüber hinaus wird die Aufgabe erfindungsgemäß gelöst durch die Verwendung eines magneto-optischen Sensors zur Ermittlung eines Stromes in einem Halbleitermodul, wobei der magneto-optische Sensor ein erstes magneto-optisches Material und ein zweites magneto-optisches Material, welches sich hinsichtlich einer Empfindlichkeit vom ersten magneto-optischen Material unterscheidet, umfasst, wobei das erstes magneto-optische Material für die Ermittlung eines ersten Stromes verwendet wird, wobei das zweite magneto-optische Material für die Ermittlung eines zweiten Stromes verwendet wird und wobei der zweite Strom höher als der erste Strom ist.

Ferner wird die Aufgabe erfindungsgemäß gelöst durch ein Halbleitermodul aufweisend zumindest ein Halbleiterelement und Zuleitungen zur Kontaktierung des Halbleiterelements, eine Lichtquelle, welche zur Erzeugung eines polarisierten Lichtsignals konfiguriert ist, einen magneto-optischen Sensor, welcher im Bereich des Halbleiterelements oder zumindest einer Zuleitung angeordnet ist und welcher konfiguriert ist, das von der Lichtquelle erzeugte polarisierte Lichtsignal zu reflektieren, eine Detektionseinheit, welche zur Umwandlung des reflektierten Lichtsignals in ein elektrisches Signal konfiguriert ist und eine Auswerteeinheit, welche konfiguriert ist anhand einer Polarisation des reflektierten Lichtsignals einen Strom zu ermitteln, wobei der magneto-optische Sensors ein erstes magneto-optisches Material und ein zweites magneto-optisches Material, welches sich hinsichtlich einer Empfindlichkeit vom ersten magneto-optischen Material unterscheidet, umfasst.

Des Weiteren wird die Aufgabe erfindungsgemäß gelöst durch ein Halbleitermodul aufweisend zumindest ein Halbleiterelement und Zuleitungen zur Kontaktierung des Halbleiterelements, eine Lichtquelle, welche zur Erzeugung eines polarisierten Lichtsignals konfiguriert ist, einen magneto-optischen Sensor, welcher im Bereich des Halbleiterelements oder zumindest einer Zuleitung angeordnet ist und welcher konfiguriert ist, das von der Lichtquelle erzeugte polarisierte Lichtsignal zu transmittieren, eine Detektionseinheit, welche zur Umwandlung des transmittierten Lichtsignals in ein elektrisches Signal konfiguriert ist und eine Auswerteeinheit, welche konfiguriert ist anhand einer Polarisation des transmittierten Lichtsignals einen Strom zu ermitteln, wobei der magneto-optische Sensors ein erstes magneto-optisches Material und ein zweites magneto-optisches Material, welches sich hinsichtlich einer Empfindlichkeit vom ersten magneto-optischen Material unterscheidet, umfasst.

Darüber hinaus wird die Aufgabe erfindungsgemäß gelöst durch einen Stromrichter mit mindestens einem derartigen Halbleitermodul.

Die in Bezug auf das Verfahren nachstehend angeführten Vorteile und bevorzugten Ausgestaltungen lassen sich sinngemäß auf die Steuereinheit, das Computerprogramm, die Verwendung, das Halbleitermodul und den Stromrichter übertragen.

Der Erfindung liegt die Überlegung zugrunde, eine sensorbasierte Überwachung eines Halbleiterelements zu verbessern, indem ein magneto-optischer Sensors zur galvanisch getrennten Ermittlung eines Stromes in einem Halbleitermodul verwendet wird. Der magneto-optischer Sensor weist einen Werkstoff, insbesondere einen Dünnschicht-Film, mit magneto-optischen Eigenschaften auf. Beispielsweise enthält die magneto-optische Schicht Granat. Ein derartiger magneto-optischer Sensor wird im Bereich eines Halbleiterelements oder einer Zuleitung des Halbleiterelements angeordnet. Eine Lichtquelle erzeugt ein polarisiertes Lichtsignal, welches auf den magneto-optischen Sensor trifft und transmittiert oder reflektiert wird. Beispielsweise umfasst der magneto-optische Sensor auf einer der Lichtquelle abgewandten Seite eine, insbesondere metallische, Reflexionsschicht zur Reflexion des Lichtsignals. Aufgrund magneto-optischer Effekte, welche bei einer Transmission Faraday Effekt und bei einer Reflexion Kerr-Effekt genannt werden, sind Magnetfelder dadurch, insbesondere quantitativ, erfassbar, dass elektrisch aktive optische Kristalle oder Flüssigkeiten im magneto-optischen Sensor eine Polarisationsänderung verursachen, welche von der Feldstärke des Magnetfeldes abhängig ist. Über eine Detektionseinheit, welche **z.B.** einen opto-elektronischen Wandler mit einem vorgeschalteten Polarisationsfilter umfasst, wird das transmittierte oder reflektierte Lichtsignal in ein elektrisches Signal umwandelt. Beispielsweise weist der opto-elektronische Wandler zumindest eine lichtempfindliche Diode, **z.B.** eine Fotodiode oder eine Pin-Diode, auf. Insbesondere wird eine Lichtintensität des transmittierten oder reflektierten Lichtsignals über zumindest eine lichtempfindliche Diode, **z.B.** Fotodiode oder Pin-Diode, in einen Strom konvertiert. Anhand der Polarisation des transmittierten oder reflektierten Lichtsignals wird in einer Auswerteeinheit ein Strom ermittelt. Bei einer Reflexion des Lichtsignals durch den magneto-optischen Sensor durchdringt das Licht zwei Mal, auf dem Hin- und Rückweg, dieselbe magneto-optischen Schicht, sodass die Polarisationsänderung verstärkt wird. Daher ist beispielsweise eine dünnere Schicht verwendbar. Insbesondere magneto-optische Dünnschichten weisen genügend Sensitivität zur Erfassung von typischen Stromdichten, **d.h.** von Magnetfeldern im Bereich von Halbleiterelementen, auf. Die Ermittlung des Stromes mittels des magneto-optischen Sensors erfolgt galvanisch getrennt, sodass die Halbleiterelemente und deren Peripherie zumindest nicht merklich beeinflusst werden.

Der magneto-optische Sensor umfasst ein erstes magneto-optisches Material und ein zweites magneto-optisches Material, welches sich hinsichtlich einer Empfindlichkeit vom ersten magneto-optischen Material unterscheidet, wobei das erstes magneto-optische Material für die Ermittlung eines ersten Stromes verwendet wird, wobei das zweite magneto-optische Material für die Ermittlung eines zweiten Stromes verwendet wird und wobei der zweite Strom höher als der erste Strom ist. Dadurch wird eine Vergrößerung einer Messdynamik erreicht.

Eine weitere Ausführungsform sieht vor, dass das polarisierte Lichtsignal über einen Lichtleiter zum magneto-optischen Sensor geleitet wird. Insbesondere weist der Lichtleiter Lichtleitfasern auf, welche polarisationserhaltend ausgeführt sind. Beispielsweise weist der Lichtleiter Polymerfasern auf. Durch den Lichtleiter wird eine Störanfälligkeit reduziert und Bauraum eingespart.

Eine weitere Ausführungsform sieht vor, dass zumindest ein Teil des Lichtleiters und der magneto-optische Sensor innerhalb des Substrats verlaufend angeordnet sind, wobei das polarisierte Lichtsignal innerhalb des Substrats auf den magneto-optischen Sensor geleitet wird. Insbesondere sind zumindest ein Teil des Lichtleiters und der magneto-optische Sensor derartig im Substrat integriert, dass eine Fixierung stattfindet, sodass Vibrationen, welche eine Detektion von Polarisationsänderungen stören können, unterdrückt werden und insbesondere kleine magnetoptisch induzierte Polarisations-Drehwinkel sicher detektiert werden. Ferner ermöglicht eine Integration in das Substrat, welches elektro-optische Leiterplatte, kurz EOCB, genannt wird, eine nähere Positionierung des magneto-optischen Sensors und eine Miniaturisierung der Sensorik.

Eine weitere Ausführungsform sieht vor, dass anhand der Polarisation des Lichtsignals eine zweidimensionale Stromdichteverteilung ermittelt wird. Zur Ermittlung einer zweidimensionalen Stromdichteverteilung werden beispielsweise ein zweidimensionales Detektor-Array mit einer Mehrzahl an lichtempfindlichen Dioden und ein großflächiger magneto-optischer Sensor herangezogen. Insbesondere bei der Überwachung einer zweidimensionalen Stromdichteverteilung des zumindest einen Halbleiterelements sind Auffälligkeiten, welche zu einem Ausfall der Komponente führen können, frühzeitig erkennbar.

Eine weitere Ausführungsform sieht vor, dass der magneto-optische Sensor einen magneto-optischen Dünnschicht-Film aufweist, wobei ein transientes Stromsignal, insbesondere mit einer Amplituden Dynamik von mindestens 100 und einer Anstiegszeit im Bereich von maximal 10 μm, erfasst wird. Magneto-optische Effekte erfolgen in der Regel hochdynamisch, sodass magneto-optische Schichten schnellen Halbleiter-StromTransienten bei An- und Abschaltvorgängen leicht folgen können. Insbesondere durch schnelle lichtempfindliche Dioden, wie Fotodioden, sind mit wenig Schaltungsaufwand lokale Stromtransiente galvanisch getrennt erfassbar.

Eine weitere Ausführungsform sieht vor, dass das transiente Stromsignal durch Unterabtastung ermittelt wird. Insbesondere bei periodischen Signalen ist mittels einer Unterabtastung ein genauer Signalverlauf des schnellen transienten Stromsignals ermittelbar.

Eine weitere Ausführungsform sieht vor, dass die Unterabtastung durch ein Umrichtertaktsignal getriggert wird, wobei das Umrichtertaktsignal definiert verzögert wird. Durch eine Triggerung mit dem Umrichtertaktsignal wird eine zuverlässige Synchronisation ermöglicht. Eine definierte Verzögerung findet beispielsweise über ein, insbesondere analoges, Verzögerungsglied, beispielsweise eine Allpassschaltung, statt. Durch eine definierte Verzögerung ist eine Unterabtastung einfach und kostengünstig realisierbar.

Eine weitere Ausführungsform sieht vor, dass eine Temperatur des magneto-optischen Sensors ermittelt wird, wobei der Strom in Abhängigkeit der Temperatur des magneto-optischen Sensors und der Polarisation des Lichtsignals ermittelt wird. Die Temperatur des magneto-optischen Sensors wird beispielsweise optisch über ein zusätzliches IR-Lichtsignal. Ein Abgleich des temperaturabhängigen Polarisationsverhalten kann empirisch mittels einer Lookup-Table, mittels eines Modells und/oder mit Hilfe eines digitalen Zwillings erfolgen. Da ein Polarisationsverhalten des magneto-optischen Sensors temperaturabhängig ist, wird durch eine, insbesondere gleichzeitige, Temperaturmessung des magneto-optischen Sensors eine Genauigkeit der Ermittlung des Stromes verbessert.

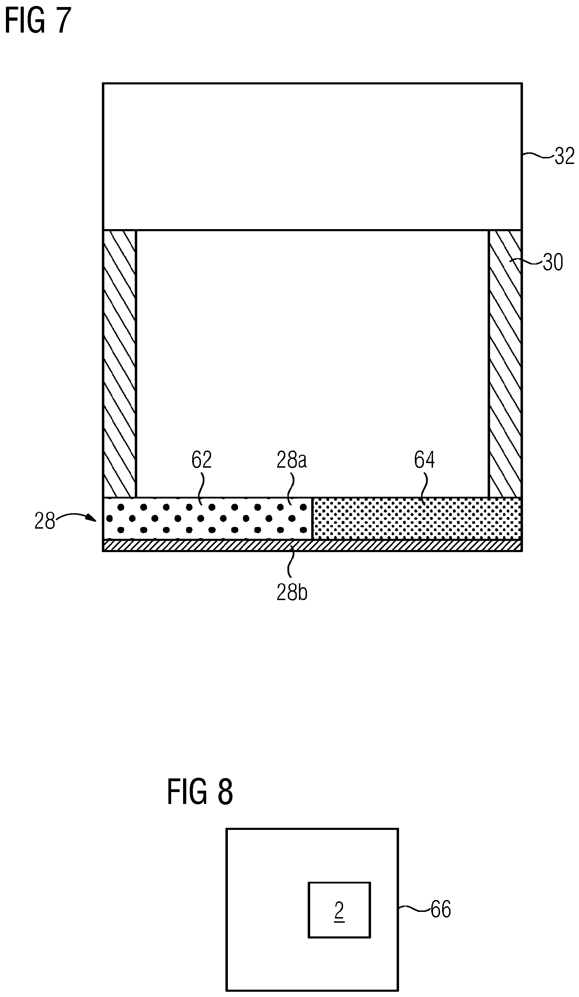

Im Folgenden wird die Erfindung anhand der in den Figuren dargestellten Ausführungsbeispiele näher beschrieben und erläutert. FIG 7 zeigt hierbei einen erfindungsgemäßen Sensor.

Es zeigen:

**EP 4 264 291 B1**

FIG 1    eine schematische Darstellung einer ersten Ausgestaltung eines Halbleitermoduls im Querschnitt,

FIG 2    eine schematische Darstellung einer zweiten Ausgestaltung eines Halbleitermoduls im Querschnitt,

FIG 3    eine dreidimensionale schematische Darstellung einer dritten Ausgestaltung eines Halbleitermoduls,

FIG 4    eine schematische Darstellung einer vierten Ausgestaltung eines Halbleitermoduls im Querschnitt,

FIG 5    eine schematische Darstellung einer fünften Ausgestaltung eines Halbleitermoduls im Querschnitt,

FIG 6    eine schematische Darstellung einer sechsten Ausgestaltung eines Halbleitermoduls,

FIG 7    eine vergrößerte schematische Darstellung eines magneto-optischen Sensors und

FIG 8    eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

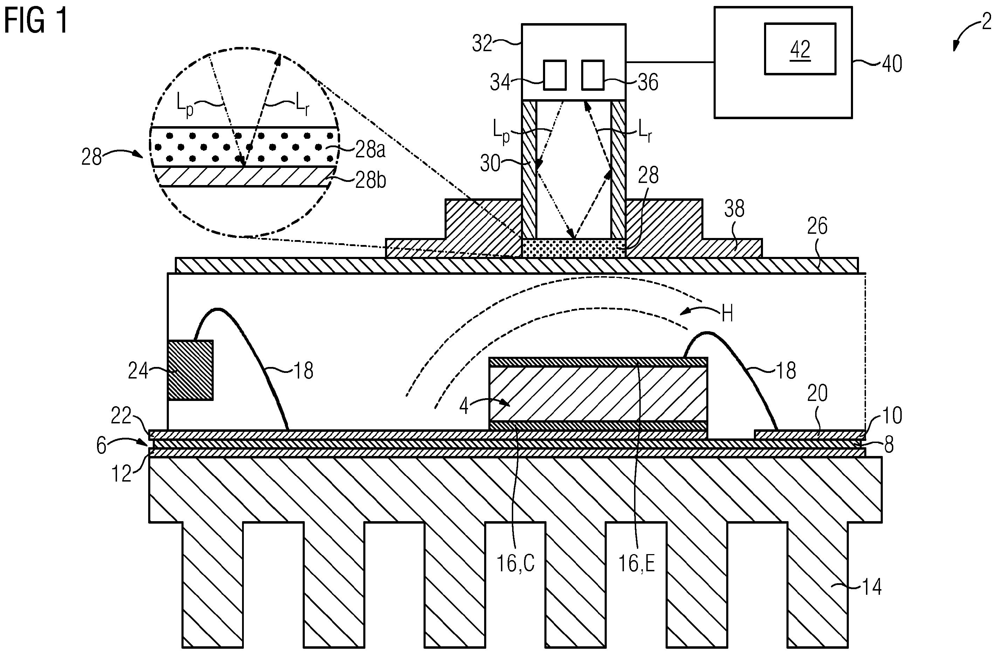

FIG 1 zeigt eine schematische Darstellung einer ersten Ausgestaltung eines Halbleitermoduls 2 im Querschnitt. Das Halbleitermodul 2 weist ein Halbleiterelement 4 und ein Substrat 6 auf, wobei das Halbleiterelement 4 exemplarisch als Insulated-Gate-Bipolar-Transistor (IGBT) ausgeführt ist. Das Halbleiterelement 4 kann auch als Metalloxide-Semiconductor-Field-Effect-Transistor (MOSFET), als Feldeffekttransistor, als Diode, als Logikbaustein, insbesondere als Field Programmable Gate Array (FPGA) oder als ein anderer Halbleiter ausgeführt sein. Insbesondere weist das Halbleiterelement 4 eine Fläche von mindestens 10 mm$^2$ auf. Das Substrat 6 umfasst eine dielektrische Materiallage 8, die einen keramischen Werkstoff, beispielsweise Aluminiumnitrid oder Aluminiumoxid, oder einen organischen Werkstoff, beispielsweise einem Polyamid enthält. Ferner weist die dielektrische Materiallage 8 eine Dicke d von 25 μm bis 400 μm, insbesondere 50 μm bis 250 μm, auf. Darüber hinaus umfasst das Substrat 6 auf einer dem Halbleiterelement 4 zugewandten Seite eine, insbesondere strukturierte, obere Metallisierung 10 und auf einer dem Halbleiterelement 4 abgewandten Seite eine untere Metallisierung 12, wobei die obere Metallisierung 10 und die untere Metallisierung 12 beispielsweise aus Kupfer hergestellt sind und auch Kupferkaschierung genannt werden. Die untere Metallisierung 12 des Substrats 6 ist, insbesondere stoffschlüssig, mit einem Kühlkörper 14 verbunden.

Das beispielhaft als IGBT ausgeführte Halbleiterelement 4 weist auf einer dem Substrat 6 zugewandten Seite ein Kontaktierungselement 16 auf, welches als Kollektor-Kontakt C ausgeführt ist, wobei ein weiteres Kontaktierungselement 16, welches als Emitter-Kontakt E ausgeführt ist, auf einer dem Substrat 6 abgewandten Seite angeordnet ist. Ein Gate-Kontakt des IGBTs ist aus Gründen der Übersichtlichkeit in FIG 1 nicht dargestellt. Der Emitter-Kontakt E ist über eine Bondverbindung 18 mit einer ersten Zuleitung 20 der oberen Metallisierung 10 des Substrats 6 verbunden, wobei der Kollektor-Kontakt C des Halbleiterelements 4 stoffschlüssig mit einer von der ersten Zuleitung 20 elektrisch isolierten zweiten Zuleitung 22 der oberen Metallisierung 10 verbunden ist. Die stoffschlüssige Verbindung ist durch Löten oder Sintern hergestellt. Die zweite Zuleitung 22 ist über eine Bondverbindung 18 mit einem elektrischen Anschlusselement 24 verbunden. Das Halbleitermodul 2 umfasst darüber hinaus ein Gehäuse 26, welches beispielsweise aus einem dielektrischen Werkstoff, insbesondere einem Kunststoff, hergestellt ist.

Ferner weist das Halbleitermodul 2 einen magneto-optischen Sensor 28 auf, welcher oberhalb des Halbleiterelements 4 mit dem Gehäuse 26 kontaktiert ist. Durch die in FIG 1 dargestellte Anordnung ist der magneto-optische Sensor 28 unter Nutzung des Kerr-Effektes konfiguriert zur Überwachung eines Stromes, insbesondere einer Stromtransienten, des Halbleiterelements **4,** wobei der magneto-optische Sensor 28 galvanisch getrennt vom Halbleiterelement 4 in einem Magnetfeld H des Halbleiterelements 4 angeordnet ist. Der magneto-optische Sensor 28 ist aus einer magneto-optischen Schicht 28a, welche beispielsweise Granat enthält, und einer reflektierenden Schicht 28b, welche beispielsweise auf die magneto-optische Schicht 28a aufgesputtert ist, aufgebaut. Die magneto-optische Schicht 28a weist insbesondere einen Dünnschicht-Film mit magneto-optischen Eigenschaften auf. Der magneto-optische Sensor 28 ist über einen Lichtleiter 30 mit einer optischen Sende- und Empfangseinheit 32, welche auch als optischer Transceiver bezeichnet wird, verbunden. Der Lichtleiter 30 weist Lichtleitfasern auf, welche polarisationserhaltend ausgeführt sind. Die optische Sende- und Empfangseinheit 32 umfasst eine Lichtquelle 34, welche ein polarisiertes Lichtsignal Lp erzeugt. Beispielsweise wird das Licht von einem Polarisator polarisiert. Das polarisierte Lichtsignal Lp wird von der reflektierenden Schicht 28b des magneto-optischen Sensors 28 reflektiert, wobei das reflektierte Lichtsignal Lr auf eine Detektionseinheit 36 trifft. Die Detektionseinheit 36 weist beispielsweise einen opto-elektronischen Wandler mit einem vorgeschalteten Polarisationsfilter auf, welche das reflektierte Lichtsignal Lr filtert und in ein elektrisches Signal umwandelt. Insbesondere wird eine Lichtintensität des reflektierten Lichtsignals Lr über zumindest eine lichtempfindliche Diode, z.B. Fotodiode oder Pin-Diode, in einen Strom konvertiert. Der Lichtleiter 30 ist über einen Steckverbinder 38 mit dem Gehäuse 26 des Halbleitermoduls 2 verbunden. Das elektrische Signal wird in einer Auswerteeinheit 40 weiterverarbeitet, wobei anhand einer Polarisation des reflektierten Lichtsignals Lr ein Strom ermittelt wird. Die Auswerteeinheit 40 weist eine Steuereinheit

5

42 auf.

In der Auswerteeinheit 40 liegen parallel zu den zeitlichen Magnetfeld Messungen H(t) des magneto-optischen Sensors 28 Ansteuer-Impulse, insbesondere Gate-Signale, vor, sodass transiente Stromsignale, z.B. mit einer Amplituden Dynamik von mindestens 100 und einer Anstiegszeit im Bereich von maximal 10 μm, erfassbar sind. Eine instantane Leistung ist ebenso ermittelbar.

Die Messung eines Polarisationswinkels F(t) ist der Ausgangpunkt und in einem Aussteuerbereich des magneto-optischen Sensors 28 ergibt sich zu jedem Zeitpunkt t ein linearer Zusammenhang zur Stromstärke I(t):

$$\mathrm{F(t) \ = \ C_{MO} \cdot H(t) \ = \ C_{MO} \cdot I(t)/(2\pi \cdot r)}$$

Bei Berücksichtigung von Eigentemperatureffekten der eingebetteten Schichten wird zunächst der Abstand r und der Polarisationswinkel $C_{MO}$= f(T) temperaturabhängig.

$$\mathrm{F(t,T) \ = \ C_{MO} \ (T) \cdot I(t)/(2\pi \cdot r(T))}$$

Die Temperaturabhängigkeit für den Polarisationswinkel kann alternativ nahe I(t)=0 bestimmt und als Korrekturterm herangezogen werden. Ist der aktuelle Strom I(t) bekannt, kann, in Gegenrichtung gerechnet, eine Temperatur ermittelt werden.

Die magneto-optischen Dünnschichten weisen genügend Sensivität zur Erfassung von typischen Stromdichten, **d.h.** von Magnetfeldern im Bereich von Halbleiterelementen 4, auf. Ferner erfolgen magneto-optische Effekte in der Regel hochdynamisch, sodass magneto-optische Schichten schnellen Halbleiter-StromTransienten bei An- und Abschaltvergängen leicht folgen können. Insbesondere durch schnelle lichtempfindliche Dioden, wie Fotodioden, ist mit wenig Schaltungsaufwand galvanisch sicher getrennte lokale Stromtransiente erfassbar.

Da ein Polarisationsverhalten des magneto-optischen Sensors 28 temperaturabhängig ist, wobei eine Polarisation mit zunehmender Temperatur abnimmt, kann durch eine, insbesondere gleichzeitige, Temperaturmessung des magneto-optischen Sensors 28 eine Genauigkeit der Ermittlung des Stromes verbessert werden. Hierzu wird eine Temperatur des magneto-optischen Sensors 28, beispielsweise optisch über ein zusätzliches IR-Lichtsignal, ermittelt. Daraufhin wird der Strom in Abhängigkeit der Temperatur des magneto-optischen Sensors 28 und der Polarisation des reflektierten Lichtsignals Lr ermittelt. Ein Abgleich des temperaturabhängigen Polarisationsverhalten kann empirisch mittels einer Lookup-Table, mittels eines Modells und/oder mit Hilfe eines digitalen Zwillings erfolgen.

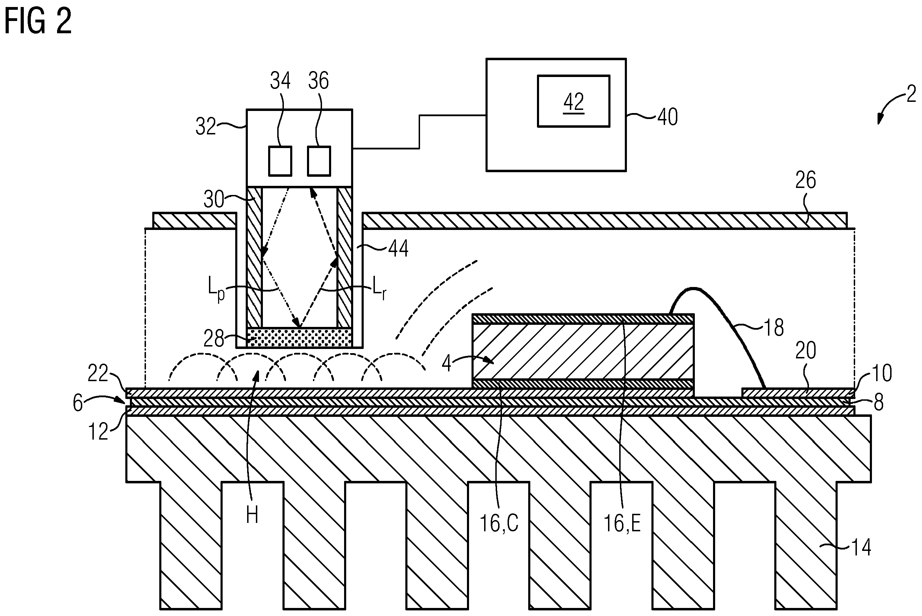

FIG 2 zeigt eine schematische Darstellung einer zweiten Ausgestaltung eines Halbleitermoduls 2 im Querschnitt, wobei ein magneto-optischer Sensor 28 in einer Kavität 44 des Gehäuses 26 oberhalb der zweiten Zuleitung 22 angeordnet ist. Durch die in FIG 2 dargestellte Anordnung ist der magneto-optische Sensor 28 unter Nutzung des Kerr-Effektes konfiguriert zur Überwachung eines Stromes, insbesondere einer Stromtransienten, im Bereich der zweiten Zuleitung 22, wobei der magneto-optische Sensor 28 in einem Magnetfeld H der zweiten Zuleitung 22 angeordnet ist. Die weitere Ausführung des Halbleitermoduls 2 in FIG 2 entspricht der in FIG 1,

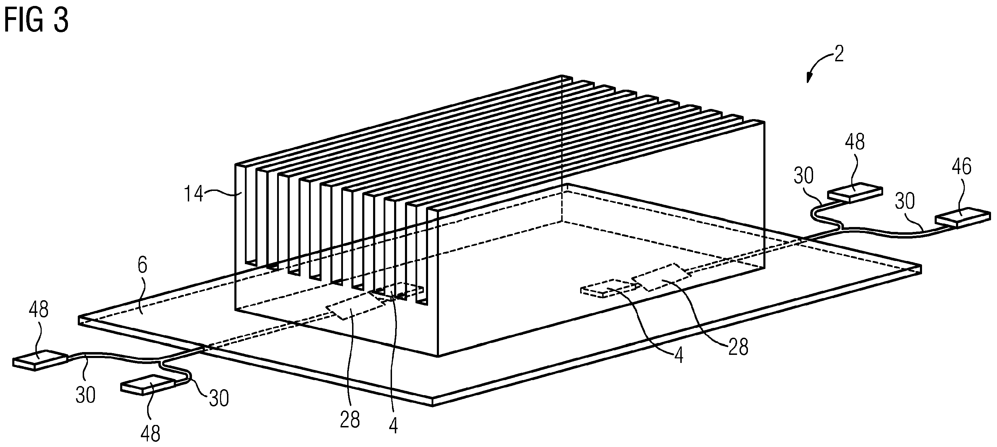

FIG 3 zeigt eine dreidimensionale schematische Darstellung einer dritten Ausgestaltung eines Halbleitermoduls 2. Halbleiterelemente 4 sind auf einem Substrat 6 kontaktiert, wobei ein Kühlkörper 14 auf einer dem Substrat 6 abgewandten Seite der Halbleiterelemente 4 thermisch mit den Halbleiterelementen 4 verbunden ist. Unterhalb der Halbleiterelemente 4 sind magneto-optische Sensoren 28 im Substrat 6 angeordnet, welche als "elektro-optischen Leiterplatte", kurz EOCB, ausgeführt sind. Die magneto-optischen Sensoren 28 sind zur dynamischen Erfassung eines lokalen Magnetfeldes und dessen transientem Verlauf, welches als Maß für die lokale Stromdichte und Halbleitertemperatur $T_{Junction}$ herangezogen wird, konfiguriert. Von einer optischen Sendeeinheit 46 wird ein von einer Lichtquelle 34 generiertes polarisiertes Lichtsignal Lp über einen Lichtleiter zum magneto-optische Sensor 28 geleitet. Das vom magneto-optischen Sensor 28 reflektierte Lichtsignal Lr wird über einen weiteren Lichtleiter 30 zu einer optische Empfangseinheit 48, welche eine Detektionseinheit 36 umfasst, geleitet. Insbesondere sind die magneto-optischen Sensoren 28 und Lichtleiter 30 in der EOCB fixiert, sodass Vibrationen, welche eine Detektion von Polarisationsänderungen stören können, unterdrückt werden. Die optischen Sendeeinheiten 46 und optischen Empfangseinheiten 48 sind beispielsweise mit einer gemeinsamen Auswerteeinheit 40 verbunden, welche aus Gründen der Übersichtlichkeit in FIG 3 nicht dargestellt ist. Insbesondere werden die Lichtquellen 34 von einer gemeinsamen Steuereinheit 42 der Auswerteeinheit 40 angesteuert. Die weitere Ausführung des Halbleitermoduls 2 in FIG 3 entspricht der in FIG 1,

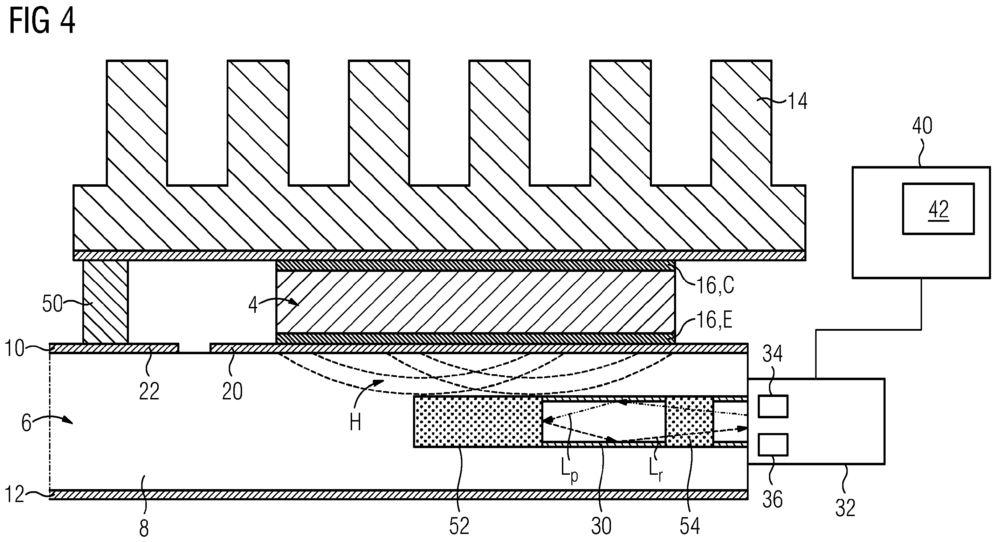

FIG 4 zeigt eine schematische Darstellung einer vierten Ausgestaltung eines Halbleitermoduls 2 im Querschnitt, welches ein Substrat 6 aufweist, auf dem ein beispielhaft als IGBT ausgeführtes Halbleiterelement 4 verbunden ist. Insbesondere ist das Halbleiterelement 4 flip-chip und mittels planarer Aufbau- und Verbindungstechnik auf dem Substrat 6 kontaktiert, wobei der Emitter E mit einer ersten Zuleitung 20 und der Kollektor C über ein Abstandshalteelement 50, auch Umsteiger genannt, mit einer zweiten Zuleitung 22 verbunden ist. Ein Gate-Kontakt des IGBTs ist aus Gründen der Übersichtlichkeit in FIG 4 nicht dargestellt.

Ein magneto-optische Sensor 28, welcher über einen Lichtleiters 30 mit einer optischen Sende- und Empfangseinheit 32 verbunden ist, ist innerhalb des Substrats 6 verlaufend angeordnet. Der magneto-optische Sensor 28 ist zusammen mit einem Lichtleiter 30 in einer Aussparung 52 einer dielektrischen Materiallage 8 des Substrats 6 integriert. Von der optischen Sende- und Empfangseinheit 32 wird ein von einer Lichtquelle 34 generiertes polarisiertes Lichtsignal Lp über einen Polarisator 54 und den Lichtleiter zum magneto-optische Sensor 28 geleitet. Das vom magneto-optischen Sensor 28 reflektierte Lichtsignal Lr wird über den Lichtleiter 30 und den Polarisator 54 zurück zur optischen Sende- und Empfangseinheit 32 reflektiert. In der Auswerteeinheit 40 wird anhand einer Polarisation des reflektierten Lichtsignals Lr ein Strom ermittelt. Die weitere Ausführung des Halbleitermoduls 2 in FIG 4 entspricht der in FIG **3**.

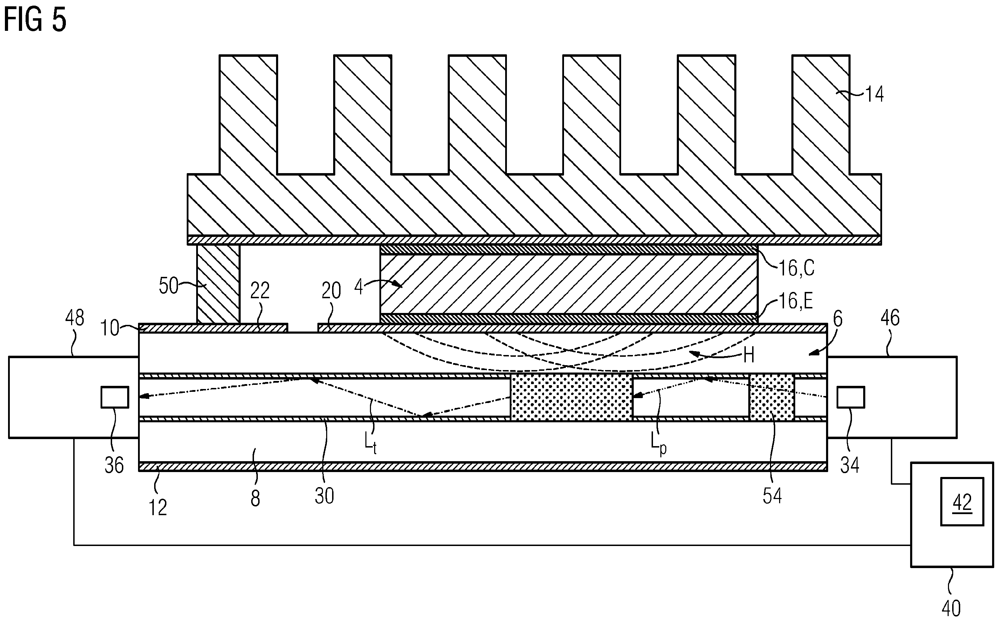

FIG 5 zeigt eine schematische Darstellung einer vierten Ausgestaltung eines Halbleitermoduls 2 im Querschnitt, wobei ein von einer Lichtquelle 34 generiertes polarisiertes Lichtsignal Lp von einer optischen Sendeeinheit 46 über einen Polarisator 54 und einen Lichtleiter 30 zum magneto-optische Sensor 28 geleitet wird. Das polarisierte Lichtsignal Lp vom magneto-optischen Sensor 28 transmittiert, wobei das transmittierte Lichtsignals Lt über einen Lichtleiter 30 zu einer optischen Empfangseinheit 48, welche eine Detektionseinheit 36 umfasst, geleitet wird. In der Auswerteeinheit 40 wird anhand einer Polarisation des transmittierten Lichtsignals Lt ein Strom ermittelt. Die weitere Ausführung des Halbleitermoduls 2 in FIG 4 entspricht der in FIG **4**.

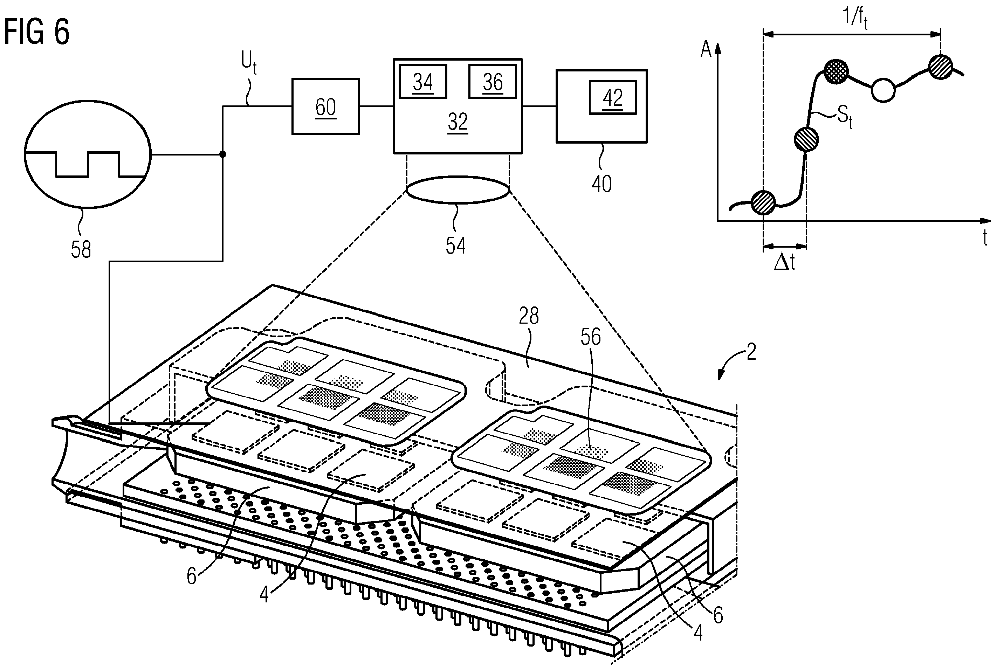

FIG 6 zeigt eine schematische Darstellung einer sechsten Ausgestaltung eines Halbleitermoduls **2**. Die optische Sende- und Empfangseinheit 32 ist als Kamera ausgeführt, wobei die Detektionseinheit 36 der Kamera ein zweidimensionales Detektor-Array aufweist zur Ermittlung einer zweidimensionalen Stromdichteverteilung 56 aufweist. Hierzu wird ein magneto-optischer Sensor 28 mit einer großflächigen magneto-optischen Schicht 28 herangezogen. Ein von einer der Kamera zugewiesenen Lichtquelle 34 generiertes polarisiertes Lichtsignal Lp wird über einen Polarisator 54 zum großflächigen magneto-optische Sensor 28 geleitet. Das vom magneto-optischen Sensor 28 reflektierte Lichtsignal Lr wird über den Polarisator 54 zurück zur Kamera reflektiert. In der Auswerteeinheit 40 wird anhand einer Polarisation des reflektierten Lichtsignals Lr ein Strom ermittelt.

Um ein transientes Stromsignal St, welches eine Amplituden Dynamik von mindestens 100 und eine Anstiegszeit im Bereich von maximal 10 $\mu$m aufweist, zu erfassen, wird eine Unterabtastung durchgeführt, welche durch ein von einem Signalgenerator 58 erzeugtes Umrichtertaktsignal Ut der Frequenz ft getriggert wird. Für die Unterabtastung wird das Umrichtertaktsignal Ut über ein Verzögerungsglied 60 um eine Verzögerungszeit $\Delta t$, welche kleiner als 1/ft ist, definiert verzögert. Die weitere Ausführung des Halbleitermoduls 2 in FIG 6 entspricht der in FIG **1**.

FIG 7 zeigt eine vergrößerte schematische Darstellung eines magneto-optischen Sensors 28, welcher ein erstes magneto-optisches Material 62 und ein zweites magneto-optisches Material 64, welches sich hinsichtlich einer Empfindlichkeit bezüglich der Feldstärke vom ersten magneto-optischen Material 62 unterscheidet, umfasst. Wie in FIG 1 dargestellt, ist der magneto-optische Sensor 28 über einen Lichtleiter 30 mit einer optischen Sende- und Empfangseinheit 32 verbunden. Die mindestens zwei magneto-optischen Materialien 62, 64 sind für unterschiedliche Feldstärken verwendbar, sodass eine Vergrößerung einer Messdynamik erreichbar ist.

FIG 8 zeigt eine schematische Darstellung eines Stromrichters 66 mit einem Halbleitermodul **2**. Der Stromrichter 66 kann mehr als ein Halbleitermodul 2 umfassen.

Zusammenfassend betrifft die Erfindung ein Verfahren zum Überwachen zumindest eines Halbleiterelements 4 in einem Halbleitermodul **2,** wobei das Halbleitermodul 2 Zuleitungen 20, 22 zur Kontaktierung des Halbleiterelements 4 aufweist. Um dynamische, insbesondere transiente, Vorgänge erfassen zu können, ohne das zumindest eine Halbleiterelement 4 und dessen Peripherie merklich zu beeinflussen, wird vorgeschlagen, dass ein magneto-optischer Sensor 28 im Bereich des Halbleiterelements 4 oder zumindest einer Zuleitung 20, 22 angeordnet ist, wobei ein polarisiertes Lichtsignal Lp vom magneto-optischen Sensor 28 reflektiert wird, wobei anhand einer Polarisation des reflektierten Lichtsignals Lr ein Strom ermittelt wird.

## Patentansprüche

**1.** Verfahren zum Überwachen zumindest eines Halbleiterelements (4) in einem Halbleitermodul (2),

> wobei das Halbleitermodul (2) Zuleitungen (20, 22) zur Kontaktierung des Halbleiterelements (4) aufweist,
> wobei ein magneto-optischer Sensor (28) im Bereich des Halbleiterelements (4) oder zumindest einer Zuleitung (20, 22) angeordnet ist,
> wobei ein polarisiertes Lichtsignal (Lp) vom magneto-optischen Sensor (28) reflektiert wird,
> wobei anhand einer Polarisation des reflektierten Lichtsignals (Lr) ein Strom ermittelt wird,
> **dadurch gekennzeichnet, dass**
> der magneto-optische Sensor (28) ein erstes magneto-optisches Material (62) und ein zweites magneto-optisches Material (64), welches sich hinsichtlich einer Empfindlichkeit vom ersten magneto-optischen Material (62) unterscheidet, umfasst,
wobei mit dem ersten magneto-optischen Material (62) ein erster Strom ermittelt wird,
wobei mit dem zweiten magneto-optischen Material (64) ein zweiter Strom ermittelt wird und
wobei der zweite Strom höher als der erste Strom ist.

2. Verfahren zum Überwachen zumindest eines Halbleiterelements (4) in einem Halbleitermodul (2),

wobei das Halbleitermodul (2) Zuleitungen (20, 22) zur Kontaktierung des Halbleiterelements (4) aufweist,
wobei ein magneto-optischer Sensor (28) im Bereich des Halbleiterelements (4) oder zumindest einer Zuleitung (20, 22) angeordnet ist,
wobei ein polarisiertes Lichtsignal (Lp) vom magneto-optischen Sensor (28) transmittiert wird,
wobei anhand einer Polarisation des transmittierten Lichtsignals (Lt) ein Strom ermittelt wird,
**dadurch gekennzeichnet, dass**
der magneto-optische Sensor (28) ein erstes magneto-optisches Material (62) und ein zweites magneto-optisches Material (64), welches sich hinsichtlich einer Empfindlichkeit vom ersten magneto-optischen Material (62) unterscheidet, umfasst,
wobei mit dem ersten magneto-optischen Material (62) ein erster Strom ermittelt wird,
wobei mit dem zweiten magneto-optischen Material (64) ein zweiter Strom ermittelt wird und
wobei der zweite Strom höher als der erste Strom ist.

3. Verfahren nach einem der Ansprüche 1 oder 2,
wobei das polarisierte Lichtsignal (Lp) über einen Lichtleiter (30) zum magneto-optischen Sensor (28) geleitet wird.

4. Verfahren nach Anspruch 3,

wobei zumindest ein Teil des Lichtleiters (30) und der magneto-optische Sensor (28) innerhalb des Substrats (6) verlaufend angeordnet sind,
wobei das polarisierte Lichtsignal (Lp) innerhalb des Substrats (6) auf den magneto-optischen Sensor (28) geleitet wird.

5. Verfahren nach einem der vorherigen Ansprüche,
wobei anhand der Polarisation des Lichtsignals (Lr, Lp) eine zweidimensionale Stromdichteverteilung ermittelt wird.

6. Verfahren nach einem der vorherigen Ansprüche,

wobei der magneto-optischen Sensor (28) einen magneto-optischen Dünnschicht-Film aufweist,
wobei ein transientes Stromsignal, insbesondere mit einer Amplituden Dynamik von mindestens 100 und einer Anstiegszeit im Bereich von maximal 10 $\mu$m, erfasst wird.

7. Verfahren nach Anspruch 6,
wobei das transiente Stromsignal durch Unterabtastung ermittelt wird.

8. Verfahren nach Anspruch 7,

wobei die Unterabtastung durch ein Umrichtertaktsignal (Ut) getriggert wird,
wobei das Umrichtertaktsignal (Ut) definiert verzögert wird.

9. Verfahren nach einem der vorherigen Ansprüche,

wobei eine Temperatur des magneto-optischen Sensors (28) ermittelt wird,
wobei der Strom in Abhängigkeit der Temperatur des magneto-optischen Sensors (28) und der Polarisation des Lichtsignals (Lr, Lt) ermittelt wird.

10. Anordnung aus Steuereinheit (42) und magneto-optischem Sensor (28) mit Mitteln zur Durchführung eines Verfahrens nach einem der Ansprüche 1 bis 9.

11. Computerprogramm zur Durchführung eines Verfahrens nach einem der Ansprüche 1 bis 9 bei Ablauf in einer Anordnung nach Anspruch 10.

12. Verwendung eines magneto-optischen Sensors (28) zur Ermittlung eines Stromes in einem Halbleitermodul (2),

wobei der magneto-optische Sensor (28) ein erstes magneto-optisches Material (62) und ein zweites magneto-optisches Material (64), welches sich hinsichtlich einer Empfindlichkeit vom ersten magneto-optischen Material (62) unterscheidet, umfasst,
wobei das erstes magneto-optische Material (62) für die Ermittlung eines ersten Stromes verwendet wird,
wobei das zweite magneto-optische Material (64) für die Ermittlung eines zweiten Stromes verwendet wird und
wobei der zweite Strom höher als der erste Strom ist.

13. Halbleitermodul (2) aufweisend:

- zumindest ein Halbleiterelement (4) und Zuleitungen (20, 22) zur Kontaktierung des Halbleiterelements (4),
- eine Lichtquelle (34), welche zur Erzeugung eines polarisierten Lichtsignals (Lp) konfiguriert ist,
- einen magneto-optischen Sensor (28), welcher im Bereich des Halbleiterelements (4) oder zumindest einer Zuleitung (20, 22) angeordnet ist und welcher konfiguriert ist, das von der Lichtquelle (34) erzeugte polarisierte Lichtsignal (Lp) zu reflektieren,
- eine Detektionseinheit (36), welche zur Umwandlung des reflektierten Lichtsignals (Lr) in ein elektrisches Signal konfiguriert ist,
- eine Auswerteeinheit (40), welche konfiguriert ist anhand einer Polarisation des reflektierten Lichtsignals (Lr) einen Strom zu ermitteln, **dadurch gekennzeichnet, dass** der magneto-optische Sensors (28) ein erstes magneto-optisches Material (62) und ein zweites magneto-optisches Material (64), welches sich hinsichtlich einer Empfindlichkeit vom ersten magneto-optischen Material (62) unterscheidet, umfasst.

14. Halbleitermodul (2) aufweisend:

- zumindest ein Halbleiterelement (4) und Zuleitungen (20, 22) zur Kontaktierung des Halbleiterelements (4),
- eine Lichtquelle (34), welche zur Erzeugung eines polarisierten Lichtsignals (Lp) konfiguriert ist,
- einen magneto-optischen Sensor (28), welcher im Bereich des Halbleiterelements (4) oder zumindest einer Zuleitung (20, 22) angeordnet ist und welcher konfiguriert ist, das von der Lichtquelle (34) erzeugte polarisierte Lichtsignal (Lp) zu transmittieren,
- eine Detektionseinheit (36), welche zur Umwandlung des transmittierten Lichtsignals (Lt) in ein elektrisches Signal konfiguriert ist,
- eine Auswerteeinheit (40), welche konfiguriert ist anhand einer Polarisation des transmittierten Lichtsignals (Lt) einen Strom zu ermitteln, **dadurch gekennzeichnet, dass** der magneto-optische Sensors (28) ein erstes magneto-optisches Material (62) und ein zweites magneto-optisches Material (64), welches sich hinsichtlich einer Empfindlichkeit vom ersten magneto-optischen Material (62) unterscheidet, umfasst.

15. Halbleitermodul (2) nach einem der Ansprüche 13 oder 14, aufweisend einen Lichtleiter (30), welcher zur Verbindung der Lichtquelle (34) und/oder der Detektionseinheit (36) mit dem magneto-optischen Sensor (28) ausgeführt ist.

16. Halbleitermodul (2) nach Anspruch 15,

aufweisend ein Substrat (6), auf welcher zumindest ein Halbleiterelement (4) über die Zuleitungen (20, 22) kontaktiert ist und
wobei zumindest ein Teil des Lichtleiters (30) und der magneto-optische Sensor (28) innerhalb des Substrats (6) verlaufend angeordnet sind.

17. Halbleitermodul (2) nach einem der Ansprüche 13 bis 16, wobei der magneto-optischer Sensor (28) maximal 1 mm entfernt vom Halbleiterelement (4) oder zumindest einer Zuleitung (20, 22) angeordnet ist.

18. Halbleitermodul (2) nach einem der Ansprüche 13 bis 17, wobei der magneto-optischen Sensor (28) einen magneto-optischen Dünnschicht-Film aufweist, welcher zur Erfassung eines transienten Stromsignal, insbesondere mit einer Amplituden Dynamik von mindestens 100 und einer Anstiegszeit im Bereich von maximal 10 $\mu$m, konfiguriert ist.

19. Stromrichter (66) mit mindestens einem Halbleitermodul (2) nach einem der Ansprüche 13 bis 18.

**Claims**

1. Method for monitoring at least one semiconductor element (4) in a semiconductor module (2),

   wherein the semiconductor module (2) has feed lines (20, 22) for making contact with the semiconductor element (4),
   wherein a magneto-optical sensor (28) is arranged in the region of the semiconductor element (4) or at least one feed line (20, 22),
   wherein a polarised light signal (Lp) is reflected by the magneto-optical sensor (28),
   wherein a current is determined from a polarisation of the reflected light signal (Lr),
   **characterised in that**
   the magneto-optical sensor (28) comprises a first magneto-optical material (62) and a second magneto-optical material (64) that differs from the first magneto-optical material (62) in respect of sensitivity,
   wherein a first current is determined using the first magneto-optical material (62),
   wherein a second current is determined using the second magneto-optical material (64), and
   wherein the second current is larger than the first current.

2. Method for monitoring at least one semiconductor element (4) in a semiconductor module (2),

   wherein the semiconductor module (2) has feed lines (20, 22) for making contact with the semiconductor element (4),
   wherein a magneto-optical sensor (28) is arranged in the region of the semiconductor element (4) or at least one feed line (20, 22),
   wherein a polarised light signal (Lp) is transmitted by the magneto-optical sensor (28),
   wherein a current is determined from a polarisation of the transmitted light signal (Lt),
   **characterised in that**
   the magneto-optical sensor (28) comprises a first magneto-optical material (62) and a second magneto-optical material (64) that differs from the first magneto-optical material (62) in respect of sensitivity,
   wherein a first current is determined using the first magneto-optical material (62),
   wherein a second current is determined using the second magneto-optical material (64), and
   wherein the second current is larger than the first current.

3. Method according to one of claims 1 or 2,
   wherein the polarised light signal (Lp) is guided to the magneto-optical sensor (28) by way of a fibre-optic conductor (30).

4. Method according to claim 3,

   wherein the fibre-optic conductor (30), at least in part, and the magneto-optical sensor (28) are arranged to run within the substrate (6),
   wherein the polarised light signal (Lp) is guided within the substrate (6), onto the magneto-optical sensor (28).

5. Method according to one of the preceding claims,
   wherein a two-dimensional current density distribution is determined from the polarisation of the light signal (Lr, Lp).

6. Method according to one of the preceding claims,

   wherein the magneto-optical sensor (28) has a magneto-optical thin film,
   wherein a transient current signal, in particular having an amplitude dynamic of at least 100 and a rise time in the region of at most 10 $\mu$m, is detected.

7. Method according to claim 6,
   wherein the transient current signal is determined by undersampling.

8. Method according to claim 7,

   wherein the undersampling is triggered by a frequency converter clock signal (Ut),
   wherein the frequency converter clock signal (Ut) is subject to a defined delay.

9. Method according to one of the preceding claims,

wherein a temperature of the magneto-optical sensor (28) is determined,
wherein the current is determined in a manner dependent on the temperature of the magneto-optical sensor (28) and the polarisation of the light signal (Lr, Lt).

10. Arrangement consisting of control unit (42) and magneto-optical sensor (28) having means for carrying out a method according to one of claims 1 to 9.

11. Computer program for carrying out a method according to one of claims 1 to 9 when it is run in an arrangement according to claim 10.

12. Use of a magneto-optical sensor (28) for determining a current in a semiconductor module (2),

wherein the magneto-optical sensor (28) comprises a first magneto-optical material (62) and a second magneto-optical material (64) that differs from the first magneto-optical material (62) in respect of sensitivity,
wherein the first magneto-optical material (62) is used for determining a first current,
wherein the second magneto-optical material (64) is used for determining a second current, and
wherein the second current is larger than the first current.

13. Semiconductor module (2), having:

- at least one semiconductor element (4) and feed lines (20, 22) for making contact with the semiconductor element (4),
- a light source (34) that is configured to generate a polarised light signal (Lp),
- a magneto-optical sensor (28) that is arranged in the region of the semiconductor element (4) or at least one feed line (20, 22) and is configured to reflect the polarised light signal (Lp) generated by the light source (34),
- a detection unit (36) that is configured to convert the reflected light signal (Lr) into an electrical signal,
- an evaluation unit (40) that is configured to determine a current from a polarisation of the reflected light signal (Lr),

**characterised in that**
the magneto-optical sensor (28) comprises a first magneto-optical material (62) and a second magneto-optical material (64) that differs from the first magneto-optical material (62) in respect of sensitivity.

14. Semiconductor module (2), having:

- at least one semiconductor element (4) and feed lines (20, 22) for making contact with the semiconductor element (4),
- a light source (34) that is configured to generate a polarised light signal (Lp),
- a magneto-optical sensor (28) that is arranged in the region of the semiconductor element (4) or at least one feed line (20, 22) and is configured to transmit the polarised light signal (Lp) generated by the light source (34),
- a detection unit (36) that is configured to convert the transmitted light signal (Lt) into an electrical signal,
- an evaluation unit (40) that is configured to determine a current from a polarisation of the transmitted light signal (Lt),

**characterised in that**
the magneto-optical sensor (28) comprises a first magneto-optical material (62) and a second magneto-optical material (64) that differs from the first magneto-optical material (62) in respect of sensitivity.

15. Semiconductor module (2) according to one of claims 13 or 14,
having a fibre-optic conductor (30) that is configured to connect the light source (34) and/or the detection unit (36) to the magneto-optical sensor (28).

16. Semiconductor module (2) according to claim 15,

having a substrate (6) on which at least one semiconductor element (4) makes contact by way of the feed lines (20, 22), and

wherein the fibre-optic conductor (30), at least in part, and the magneto-optical sensor (28) are arranged to run within the substrate (6).

17. Semiconductor module (2) according to one of claims 13 to 16,
    wherein the magneto-optical sensor (28) is arranged at most 1 mm away from the semiconductor element (4) or at least one feed line (20, 22).

18. Semiconductor module (2) according to one of claims 13 to 17,
    wherein the magneto-optical sensor (28) has a magneto-optical thin film that is configured to detect a transient current signal, in particular having an amplitude dynamic of at least 100 and a rise time in the region of at most 10 $\mu$m.

19. Power converter (66) having at least one semiconductor module (2) according to one of claims 13 to 18.


**Revendications**

1. Procédé de contrôle d'au moins un élément (4) à semiconducteur dans un module (2) de semiconducteur,

    dans lequel le module (2) de semiconducteur a des lignes (20, 22) d'arrivée pour la mise en contact de l'élément (4) à semiconducteur,
    dans lequel un capteur (28) magnéto-optique est disposé dans la zone de l'élément (4) à semiconducteur ou du moins d'une ligne (20, 22) d'arrivée,
    dans lequel un signal (Lp) lumineux polarisé est réfléchi par le capteur (28) magnéto-optique,
    dans lequel, à l'aide d'une polarisation du signal (Lr) lumineux réfléchi, on détermine un courant,
    **caractérisé en ce que**
    le capteur (28) magnéto-optique comprend un premier matériau (62) magnéto-optique et un deuxième matériau (64) magnéto-optique, qui se distingue en ce qui concerne une sensibilité du premier matériau (62) magnéto-optique,
    dans lequel on détermine un premier courant par le premier matériau (62) magnéto-optique,
    dans lequel on détermine un deuxième courant par le deuxième matériau (64) magnéto-optique et
    dans lequel le deuxième courant est plus grand que le premier courant.

2. Procédé de contrôle d'au moins un élément (4) à semiconducteur dans un module (2) de semiconducteur,

    dans lequel le module (2) de semiconducteur a des lignes (20, 22) d'arrivée pour la mise en contact de l'élément (4) à semiconducteur,
    dans lequel un capteur (28) magnéto-optique est disposé dans la zone de l'élément (4) à semiconducteur ou du moins d'une ligne (20, 22) d'arrivée,
    dans lequel un signal (Lp) lumineux polarisé est transmis par le capteur (28) magnéto-optique,
    dans lequel on détermine un courant, à l'aide d'une polarisation du signal (Lt) lumineux transmis,
    **caractérisé en ce que**
    le capteur (28) magnéto-optique comprend un premier matériau (62) magnéto-optique et un deuxième matériau (64) magnéto-optique, qui se distingue en ce qui concerne une sensibilité du premier matériau (62) magnéto-optique,
    dans lequel on détermine un premier courant par le premier matériau (62) magnéto-optique,
    dans lequel on détermine un deuxième courant par le deuxième matériau (64) magnéto-optique et
    dans lequel le deuxième courant est plus grand que le premier courant.

3. Procédé suivant l'une des revendications 1 ou 2,
    dans lequel on envoie le signal (Lp) lumineux polarisé au capteur (28) magnéto-optique en passant par un conducteur (30) de lumière.

4. Procédé suivant la revendication 3,

    dans lequel au moins une partie du conducteur (30) lumière et du capteur (28) magnéto-optique sont disposées en s'étendant au sein du substrat (6),
    dans lequel le signal (Lp) lumineux polarisé au sein du substrat (6) est envoyé sur le capteur (28) magnéto-optique.

**5.** Procédé suivant l'une des revendications précédentes,
dans lequel, à l'aide de la polarisation du signal (Lr, Lp) lumineux, on détermine une répartition de densité du courant en deux dimensions.

**6.** Procédé suivant l'une des revendications précédentes,

dans lequel le capteur (28) magnéto-optique a un film en couche mince magnéto-optique,
dans lequel on détecte un signal de courant transitoire, ayant en particulier une dynamique d'amplitude d'au moins 100 et un temps de montée dans la plage 10 $\mu$m au maximum.

**7.** Procédé suivant la revendication 6,
dans lequel on détermine le signal de courant transitoire par sous-échantillonnage.

**8.** Procédé suivant la revendication 7,

dans lequel on déclenche le sous-échantillonnage par un signal (Ut) d'horloge de convertisseur,
dans lequel on retarde de manière définie le signal (Ut) d'horloge de convertisseur.

**9.** Procédé suivant l'une des revendications précédentes,

dans lequel on détermine une température du capteur (28) magnéto-optique,
dans lequel on détermine le courant en fonction de la température du capteur (28) magnéto-optique et de la polarisation du signal (Lr, Lt) lumineux.

**10.** Agencement composé d'une unité (42) de commande et d'un capteur (28) magnéto-optique, comprenant des moyens pour effectuer un procédé suivant l'une des revendications 1 à 9.

**11.** Programme d'ordinateur pour effectuer un procédé suivant l'une des revendications 1 à 9, lorsqu'il se déroule dans un agencement suivant la revendication 10.

**12.** Utilisation d'un capteur (28) magnéto-optique pour la détermination d'un courant dans un module (2) de semiconducteur,

dans lequel le capteur (28) magnéto-optique comprend un premier matériau (62) magnéto-optique et un deuxième matériau (64) magnéto-optique, qui se distingue en ce qui concerne une sensibilité du premier matériau (62) magnéto-optique,
dans lequel on utilise le premier matériau (62) magnéto-optique pour la détermination d'un premier courant,
dans lequel on utilise le deuxième matériau (64) magnéto-optique pour la détermination d'un deuxième courant,
dans lequel le deuxième courant est plus grand que le premier courant.

**13.** Module (2) de semiconducteur comportant :

- au moins un élément (4) à semiconducteur et des lignes (20, 22) d'arrivée pour la mise en contact de l'élément (4) à semiconducteur,
- une source (34) lumineuse, qui est configurée pour la production d'un signal (Lp) lumineux polarisé,
- un capteur (28) magnéto-optique, qui est disposé dans la zone de l'élément (4) à semiconducteur ou d'au moins une ligne (20, 22) d'arrivée et qui est configuré pour réfléchir le signal (Lp) lumineux polarisé produit par la source (34) lumineuse,
- une unité (36) de détection, qui est configurée pour la transformation du signal (Lr) lumineux réfléchi en un signal électrique,
- une unité (40) d'évaluation, qui est configurée pour, à l'aide d'une polarisation du signal (Lr) lumineux réfléchi, déterminer un courant,

**caractérisé en ce que**
le capteur (28) magnéto-optique comprend un premier matériau (62) magnéto-optique et un deuxième matériau (64) magnéto-optique, qui se distingue en ce qui concerne une sensibilité du premier matériau (62) magnéto-optique.

**14.** Module (2) de semiconducteur, comportant :

- au moins un élément (4) à semiconducteur et des lignes (20, 22) d'arrivée pour la mise en contact de l'élément (4) à semiconducteur,
- une source (34) lumineuse, qui est configurée pour la production d'un signal (Lp) lumineux polarisé,
- un capteur (28) magnéto-optique, qui est disposé dans la zone de l'élément (4) à semiconducteur d'au moins une ligne (20, 22) d'arrivée et qui est configuré pour transmettre le signal (Lp) lumineux polarisé produit par le source (34) lumineuse,
- une unité (36) de détection, qui est configurée pour la transformation du signal (Lt) lumineux réfléchi en un signal électrique,
- une unité (40) d'évaluation, qui est configurée pour déterminer un courant à l'aide d'une polarisation du signal (Lt) lumineux réfléchi,

**caractérisé en ce que**
le capteur (28) magnéto-optique comprend un premier matériau (62) magnéto-optique et un deuxième matériau (64) magnéto-optique, qui se distingue en ce qui concerne une sensibilité du premier matériau (62) magnéto-optique.

15. Module (2) de semiconducteur suivant l'une des revendications 13 ou 14,
comportant un conducteur (30) de lumière, qui est réalisé pour le raccordement de la source (34) lumineuse et/ou d'une unité (36) de détection au capteur (28) magnéto-optique.

16. Module (2) de semiconducteur suivant la revendication 15,

comportant un substrat (6) sur lequel au moins un élément (4) à semiconducteur est mis en contact par les lignes (20, 22) d'arrivée, et

dans lequel au moins une partie du conducteur (30) de lumière et du capteur (28) magnéto-optique sont disposées en s'étendant au sein du substrat (6).

17. Module (2) de semiconducteur suivant l'une des revendications 13 à 16,
dans lequel le capteur (28) magnéto-optique est éloigné au maximum de 1 mm de l'élément (4) à semiconducteur ou du moins d'une ligne (20, 22) d'arrivée.

18. Module (2) de semiconducteur suivant l'une des revendications 13 à 17,
dans lequel le capteur (28) magnéto-optique a un film en couche mince magnéto-optique, qui est configuré pour la détection d'un signal de courant transitoire ayant, en particulier une dynamique d'amplitude d'au moins 100 et un temps de montée dans la plage de 10 $\mu$m au maximum.

19. Convertisseur (66) de courant comprenant au moins un module (2) de semiconducteur suivant l'une des revendications 13 à 18.

FIG 1

FIG 2

EP 4 264 291 B1

FIG 3

FIG 4

EP 4 264 291 B1

# FIG 5

# FIG 6

EP 4 264 291 B1

FIG 7

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3358359 A1

- DE 102012002984 A1

**In der Beschreibung aufgeführte Nicht-Patentliteratur**

- **KOSCHNY, MARCO** ; **LINDNER, MORRIS** ; **RICHERT, HENDRYK, QUALITY**. *Magneto-Optical Sensors*, 2012, vol. 51, ISSN 03609936, 6-9
- **SHINICHI OHKOSHI** ; **KENTA IMOTO** ; **ASUKA NAMAI** ; **MARIE YOSHIKIYO** ; **SEIJI MIYASHITA** ; **HONGSONG QIU** ; **SHODAI KIMOTO** ; **KOSAKU KATO** ; **MAKOTO NAKAJIMA**. Rapid Faraday Rotation on $\varepsilon$-Iron Oxide Magnetic Nanoparticles by Visible and Terahertz Pulsed Light. *Journal of the American Chemical Society*, 2019, vol. 141 (4), 1775-1780

- Direct current imaging using a magneto-optical sensor. **ARAKELYAN SHANT et al.** Sensors and Actuators: Physical. Elsevier BV, 11 January 2016, 397-401